# EUROPÄISCHE PATENTSCHRIFT

(11) **EP 4 555 485 B1**
(45) Veröffentlichungstag und Bekanntmachung des Hinweises auf die Patenterteilung: **08.04.2026**
(21) Anmeldenummer: 23732901.6
(22) Anmeldetag: 13.06.2023
(51) Int. Cl.: G06T 17/00, G06T 15/20

(54) **DESIGNVORRICHTUNG UND VERFAHREN ZUM BEREITSTELLEN EINES 3D-MODELLS FÜR EINE DESIGNENTWICKLUNG EINES OBJEKTS**
DESIGNING DEVICE, AND METHOD FOR PROVIDING A 3D MODEL FOR A DESIGN DEVELOPMENT PROCESS OF AN OBJECT
DISPOSITIF DE CONCEPTION ET PROCÉDÉ DE FOURNITURE D'UN MODÈLE 3D POUR UN PROCESSUS DE DÉVELOPPEMENT DE CONCEPTION D'UN OBJET

(30) Priorität: 12.07.2022 DE 102022117313
(43) Veröffentlichungstag der Anmeldung: 21.05.2025
(73) Patentinhaber: AUDI AG, 85057 Ingolstadt (DE)
(72) Erfinder: HERBST, Sebastian, 85077 Manching (DE); ROSOV, Vladislav, 81671 München (DE); SIRIGATTI, Daniele, 85049 Ingolstadt (DE)
(74) Vertreter: Hofstetter, Schurack & Partner
(86) Internationale Anmeldenummer: PCT/EP2023/065791
(87) Internationale Veröffentlichungsnummer: WO 2024/012788

(56) Entgegenhaltungen:
- RADHAKRISHNAN SREEDHAR ET AL: "Creative Intelligence - Automating Car Design Studio with Generative Adversarial Networks (GAN)", 24 August 2018, 16TH EUROPEAN CONFERENCE - COMPUTER VISION - ECCV 2020, CORNELL UNIVERSITY LIBRARY, 201 OLIN LIBRARY CORNELL UNIVERSITY ITHACA, NY 14853, PAGE(S) 160 - 175, XP047605846
- YUXUAN ZHANG ET AL: "Image GANs meet Differentiable Rendering for Inverse Graphics and Interpretable 3D Neural Rendering", ARXIV.ORG, CORNELL UNIVERSITY LIBRARY, 201 OLIN LIBRARY CORNELL UNIVERSITY ITHACA, NY 14853, 20 April 2021 (2021-04-20), XP081925966
- SANGEUN OH ET AL: "Deep Generative Design: Integration of Topology Optimization and Generative Models", ARXIV.ORG, CORNELL UNIVERSITY LIBRARY, 201 OLIN LIBRARY CORNELL UNIVERSITY ITHACA, NY 14853, 1 March 2019 (2019-03-01), XP081662706, DOI: 10.1115/1.4044229
- LEIMKÜHLER THOMAS ET AL: "FreeStyleGAN", ACM TRANSACTIONS ON GRAPHICS, ACM, NY, US, vol. 40, no. 6, 10 December 2021 (2021-12-10), pages 1 - 15, XP059130520, ISSN: 0730-0301, DOI: 10.1145/3478513.3480538

## Beschreibung

Die Erfindung betrifft ein Verfahren zum Bereitstellen eines 3D-Modells für eine Designentwicklung eines Objekts. Des Weiteren betrifft die Erfindung eine Designvorrichtung, die dazu ausgebildet ist, das Verfahren durchzuführen.

Die Erstellung einer 3D-CAD-Geometrie ist ein wichtiger Meilenstein in der der Designprozessphase, um ein Gefühl über die richtigen Proportionen, technischen Randbedingungen und das Produkt/Objekt im Allgemeinen zu bekommen. Dabei wird bisher basierend auf 2D-Skizzen oder Fotos eine 3D-Geometrie mittels einer CAD (computer aided design) Software von einem Designer generiert. Die Erstellung dieser 3D-Geometrien wird über mehrere Designreviews mit Engineering- und Designteams verbessert, bis eine bestimmte technische und gestalterische Reife erreicht ist. Hierbei werden üblicherweise 2D-Skizzen erstellt, wobei oftmals mehrere Anpassungen für jede der 2D-Skizzen durchgeführt werden. Dann wird basierend auf den 2D-Skizzen ein 3D-Model mittels CAD erstellt, wobei basierend auf dem 3D-Modell Renderings für die Entscheidungsfinder erzeugt werden, was oftmals auch mehrere Iterationen benötigt.

Dieses Vorgehen hat mehrere Nachteile, insbesondere bei 2D-Skizzen sind mehrere Skizzen pro Perspektive für ein 3D-Objekt notwendig und bei einer Änderung des Designs muss jede Perspektive einzeln angepasst werden, was bedeutet, dass jede inkrementelle Anpassung des Designs zu einer Vielzahl von Anpassungen in den Skizzen führt. Des Weiteren entsteht ein Medienbruch beim Übergang zu dem 3-dimensionalen Modell, das auf den 2D-Skizzen basiert, wobei die Erstellung der 3D-Modelle meist von speziellen Fachleuten durchgeführt werden muss. Auch hier entsteht durch eine inkrementelle Anpassung des Designs eine manuell aufwendige Anpassung des 3D-Modells und es ist eine aufwendige Kommunikation zwischen Designern und CAD-Fachpersonen notwendig, da eine 2D-Skizze oftmals nicht genug Informationen beinhaltet, um ein 3D-Modell richtig zu beschreiben und folglich zu erstellen.

Ferner beschreibt die Druckschrift S. Radhakrishnan et al, "Creative Intelligence - Automating Car Design Studio with Generative Adversarial Networks (GAN)", 16th European Conference - Computer Vision - ECCV 2020, Cornell University Library, 201, Ithaca, NY 14853, pp. 160 - 175 (24.08.2018), ein System, das auf generativen adversen Netzwerken (GANS) basiert, um neuartige Autodesigns aus einer minimalen Designstudio-Skizze zu erstellen.

Daher ist die Aufgabe der Erfindung, eine Designentwicklung eines Objekts zu vereinfachen und/oder zu beschleunigen.

Diese Aufgabe wird durch die unabhängigen Patentansprüche gelöst. Vorteilhafte Weiterbildungen der Erfindung sind in den abhängigen Patentansprüchen, der folgenden Beschreibung sowie den Figuren offenbart.

Durch die Erfindung ist ein Verfahren zum Bereitstellen eines 3D-Modells für eine Designentwicklung eines Objekts durch Durchführung des Verfahrens auf einer Rechenvorrichtung bereitgestellt. Dabei umfasst das Verfahren die folgenden Schritte, die durch eine Rechenvorrichtung, insbesondere einen Prozessor und/oder Mikrochip, durchgeführt werden. Das Verfahren umfasst ein Vorgeben einer Objektart für oder an zumindest ein angelerntes künstliches neuronales Netzwerk, wobei das mindestens eine künstliche neuronale Netzwerk mit einer Mehrzahl von Basisbilddaten von Objekten dieser Objektart angelernt wird. Das bedeutet, dass zunächst eine Objektart, durch die eine Art des Objekts festgelegt wird, das designt werden soll, vorgegeben werden kann. Beispielsweise kann die Objektart einer Rechenvorrichtung beziehungsweise einem Computerprogramm vorgegeben werden, das dazu ausgebildet ist, das Verfahren durchzuführen. Mit der Objektart kann beispielsweise für das Programm definiert werden, ob als Objekt eine Kraftfahrzeugkomponente, wie beispielsweise eine Karosserie, Felgen, eine Interieurkomponente und/oder Komponenten auf anderen Gebieten abseits der Kraftfahrzeugtechnologie, erzeugt werden soll. Die Objektart kann dem Computerprogramm beziehungsweise dem angelernten künstlichen neuronalen Netzwerk beispielsweise mithilfe einer grafischen Benutzeroberfläche (GUI) vorgegeben werden.

Das zumindest eine künstliche neuronale Netzwerk kann beispielsweise generative gegnerische Netzwerke (GAN; generative adversarial Networks) umfassen. Als künstliches neuronales Netz, das oftmals als artificial neural Network bezeichnet wird, wird ein Netz aus künstlichen Neuronen verstanden, das für maschinelles Lernen und künstliche Intelligenz eingesetzt wird. Computerbasiert lassen sich mithilfe eines künstlichen neuronalen Netzwerks diverse Problemstellungen lösen. Letztendlich ist ein künstliches neuronales Netzwerk ein Algorithmus, anhand dessen sich verschiedene Datenquellen, wie zum Beispiel Bilddaten, interpretieren und Informationen oder Muster aus diesen extrahieren lassen, um die extrahierten Informationen oder Muster auf bisher unbekannte Daten anzuwenden. Letztendlich können dadurch datengetriebene Vorhersagen erstellt werden, sodass beispielsweise künstliche Daten erzeugt werden, die aus angelernten Daten durch das künstliche neuronale Netzwerk erzeugt werden. Das künstliche neuronale Netzwerk kann mit Bilddaten angelernt sein, insbesondere mit Basisbilddaten von Objekten der vorgegebenen Objektart.

Mit anderen Worten können die Basisbilddaten Trainingsdaten für das künstliche neuronale Netzwerk sein, die von mehreren Objekten stammen, die die gleiche Objektart aufweisen. Beispielsweise kann das Objekt, für das ein neues Design entwickelt werden soll, ein Kraftfahrzeug sein, wobei für die Designentwicklung des Kraftfahrzeugs eine Objektart vorgegeben werden kann, die durch das Verfahren entworfen werden soll, zum Beispiel eine Fahrzeugkarosserie oder Felgen des Kraftfahrzeugs. Folglich kann das künstliche neuronale Netz dann vorzugsweise mit Basisbilddaten von unterschiedlichen Fahrzeugkarosserien oder Felgen, insbesondere von einer Mehrzahl unterschiedlicher Kraftfahrzeuge, angelernt werden. Diese Basisbilddaten können also eine Menge an mehreren Bildern umfassen, wobei die einzelnen Bilder jeweils verschiedene Ausgestaltungen der Objektart umfassen. Es kann beispielsweise vorgesehen sein, dass ein Trainingsvorgang dem beschriebenen Verfahrensschritt vorgeschaltet ist, in dessen Rahmen ausgehend von einem Datensatz von Basisbilddaten von realen oder künstlichen Objekten der Objektart das GAN trainiert wird. Durch Anwenden des GAN können daraus dann durch die künstliche Intelligenz neue Bilder generiert werden, die auf Bildeigenschaften der Basisbilddaten basieren.

Als weiterer Verfahrensschritt erfolgt ein Erzeugen eines Bilddatensatzes der vorgegebenen Objektart durch das angelernte künstliche neuronale Netzwerk, wobei das künstliche neuronale Netzwerk als Bilddatensatz Bilddaten der Objektart aus mehreren unterschiedlichen Perspektiven bereitstellt, die aus den Basisbilddaten ermittelt werden, mit denen das künstliche neuronale Netzwerk angelernt wurde.

Mit anderen Worten kann das angelernte künstliche neuronale Netzwerk neue Bilddaten basierend auf den angelernten Basisbilddaten erstellen, insbesondere für mehrere unterschiedliche Perspektiven beziehungsweise Ansichten auf das Objekt mit der vorgegebenen Objektart. Hierbei kann das künstliche neuronale Netzwerk ausgewählt werden, das mit Basisbilddaten der gleichen Objektart angelernt wurde, um damit die künstlichen Bilddaten in den jeweiligen unterschiedlichen Perspektiven auf das Objekt zu erzeugen, wobei mit Bilddaten 2D-Ansichten aus den unterschiedlichen Perspektiven gemeint sind.

In einem nächsten Schritt wird der erzeugte Bilddatensatz auf Vorliegen eines Designauswahlkriteriums durch ein weiteres neuronales Netzwerk automatisch geprüft, wobei Bilddaten einer oder mehrerer Perspektiven mittels einer Veränderung eines Bildeigenschaftskriteriums neu erzeugt werden, falls das Designauswahlkriterium nicht vorliegt. Das Designauswahlkriterium kann beispielsweise umfassen, ob Bildeigenschaften in den jeweiligen Perspektiven der Bilddaten zusammenpassen beziehungsweise miteinander konsistent sind. Falls zum Beispiel ein Farbunterschied zwischen zwei perspektiven vorliegen würde, wäre das eine Inkonsistenz, wobei in diesem Fall das Designauswahlkriterium nicht vorliegen würde. Im Beispiel der Fahrzeugkarosserie können beispielweise auch unterschiedliche Modelltypen, beispielsweise in einer Perspektive eine Limousine und in einer anderen Perspektive ein Kombi dargestellt sein, was einer Inkonsistenz entsprechen würde und somit das Designauswahlkriterium nicht erfüllt ist. Alternativ oder zusätzlich kann das Designauswahlkriterium auch von einem Designempfinden eines Designers abhängen, also ein ästhetisches Kriterium sein. Hierbei kann der Designer die Bilddaten beispielsweise manuell freigeben oder nicht.

Liegt das Designauswahlkriterium nicht vor, können die Bilddaten einer oder mehrerer Perspektiven durch das künstliche neuronale Netzwerk neu erzeugt werden, indem ein Bildeigenschaftskriterium verändert wird. Hierbei kann das Bildeigenschaftskriterium eine Vorschrift, einen Algorithmus, Daten und/oder Informationen aufweisen, anhand derer die Bilddaten verändert werden können. Insbesondere können mehrere der erzeugten Bilddaten einer Perspektive durch Veränderung des Bildeigenschaftskriteriums mittels einer Interpolation und/oder Rekombination von Bildeigenschaften beziehungsweise Teilbilddaten der generierten Bilddaten neu erzeugt werden. Beispielsweise können bei Verwendung eines GAN einer oder mehrere latente Vektoren verändert werden, um die Bilddaten von zumindest einer Perspektive zu verändern.

Bei der Interpolation wird bevorzugt eine Interpolation zwischen zumindest zwei bereitgestellten Bilddaten des Bilddatensatzes durchgeführt. Bevorzugt wird eine besondere Ausgestaltung des GAN verwendet, und zwar ein stylebasiertes GAN. Das erste künstliche neuronale Netzwerk des stylebasierten GAN dient mathematisch betrachtet einer Abbildung von Zufallsvektoren in einem intermediären latenten Raum. Dafür kann beispielsweise linear zwischen zwei oder mehreren latenten Vektoren des Bilddatensatzes, die jeweils einem der mindestens zwei bereitgestellten Bilddaten zugeordnet sind, interpoliert werden. Hierbei wird ein weiterer latenter Vektor errechnet, der von den mindestens zwei bereitgestellten Bilddaten abweichenden weiteren Bilddaten zugeordnet ist, wobei dieser weitere latente Vektor Bilddaten zugeordnet ist, die zwischen den bereitgestellten zwei latenten Vektoren des Bilddatensatzes liegen. Mathematisch betrachtet wird bei der Interpolation eine durch den Bilddatensatz, der als eine Art Bilddatenraum oder latenter Bildraum verstanden werden kann, verlaufende Gerade generiert, die die zwei bereitgestellten Bilddaten verbindet. Jeder Ort auf dieser Gerade steht wiederum für weitere, an diesem Ort im Bilddatensatz angeordnete Bilddaten. Bei der Interpolation werden somit weitere Bilddaten bereitgestellt, die dem Bilddatensatz entnommen werden können.

Es kann mittels der Interpolation erreicht werden, dass ein gewichteter Mittelwert zwischen den zumindest zwei bereitgestellten Bilddaten erzeugt wird. Beispielsweise können Informationen, insbesondere Designeigenschaften, der einen Bilddaten der mindestens zwei bereitgestellten Bilddaten zu 70 Prozent übernommen werden, wohingegen Informationen der anderen Bilddaten der bereitgestellten Bilddaten nur zu 30 Prozent übernommen werden. Die Kombination dieser jeweiligen Informationen führt dann zu den von den bereitgestellten Bilddaten abweichenden weiteren Bilddaten. Letztendlich kann durch die Interpolation eine beliebige und/oder eine von einem Benutzer mittels einer entsprechenden Veränderung der latenten Vektoren ausgewählte Kombination der bereitgestellten Bilddaten im Form neuer Bilddaten erzeugt werden.

Der Rekombination liegt die Erkenntnis zugrunde, dass die Bilddaten jeweils verschiedene Bildeigenschaften beschreiben, die jeweils von Teilbilddaten der Bilddaten beschrieben werden. Beispielsweise können die bereitgestellten Bilddaten bis zu 18 Bildeigenschaften aufweisen. Die Bildeigenschaften können als unterschiedliche Informationenebenen oder Ebenen der Bilddaten verstanden werden. Die Bildeigenschaften können als abstrakte Merkmale bezeichnet werden. Einzelne oder mehrere Bildeigenschaften können beispielsweise die Anzahl von Speichen einer Felge, eine Farbgestaltung der Felge und/oder die Form der Speichen der Felge zumindest teilweise beschreiben und/oder determinieren.

Bei der Rekombination kann beispielsweise ausgewählt werden, dass bestimmte erste Bildeigenschaften der Bilddaten übernommen werden sollen, wohingegen davon abweichende zweite Bildeigenschaften von anderen Bilddaten übernommen werden sollen. Derart kann beispielsweise den erstgenannten Bilddaten eine Farbgebung einer Speiche und den zweitgenannten Bilddaten eine Anzahl der einzelnen Speichen der Felge für die Erzeugung neuer Bilddaten entnommen werden. Somit können bei der Rekombination die jeweils ausgewählten Bildeigenschaften der jeweiligen bereitgestellten Bilddaten miteinander kombiniert werden.

Mit anderen Worten basiert die Rekombination darauf, dass die Bildeigenschaften der Bilddaten auf unterschiedlichen Ebenen im künstlichen neuronalen Netzwerk generiert werden. Im Falle des GAN werden diese durch den sogenannten Generator des GAN erzeugt. Der Generator ist das künstliche neuronale Netzwerk des GAN, das nach einem Trainingsprozess mit den Basisbilddaten künstliche Bilddaten, zum Beispiel von Felgen, erzeugt, also den Bilddatensatz erzeugt. Vorzugsweise werden während des Trainingsprozesses des Generators für eine vorgegebene Objektart beziehungsweise einen vorgegebenen Objektstil, zum Beispiel einen vorgegebenen Felgenstil, mathematisch betrachtet stets mehrere latente Vektoren auf bevorzugt allen Ebenen des Generators verwendet. In einem Beispielhaften Fall des Trainingsprozesses, bei denen aus Gründen der Übersichtlichkeit hier nur zwei latente Vektoren beschrieben werden, kann beispielsweise ein erster latenter Vektor Ebenen 1 bis k zugeordnet werden, wobei ein zweiter Vektor Ebenen k+1 bis n zugeordnet ist, wobei n eine maximale Anzahl der Ebenen beschreibt. Im Fall der Anwendung des trainierten künstlichen neuronalen Netzwerks kann auf jeder Ebene ein unterschiedlicher latenter Vektor verwendet werden. Bei bevorzugt bis zu 18 derartigen Ebenen im Generator ergibt sich eine Vielzahl von möglichen, sich jeweils unterscheidenden Kombinationen von Bildeigenschaften. Bevorzugt werden bei der Rekombination mehrere bereitgestellte Bilddaten miteinander kombiniert, die sich voneinander unterscheiden, und somit der trainierte Generator mehrere unterschiedliche latente Vektoren aufweist, insbesondere bis zu n unterschiedliche Ebenen, wobei n eine Anzahl an Ebenen im trainierten Generator beschreibt. Letztendlich können hierdurch zum Beispiel eine oder mehrere neue Bilddaten mit Kombinationen von Bildeigenschaften erzeugt werden, die beispielsweise persönlichen Vorstellungen eines Designers am meisten entsprechen.

Die Bildeigenschaften, die durch die Veränderung der latenten Vektoren angepasst werden, können vorzugsweise bekannt sein, wodurch gezielt Bildeigenschaften der Bilddaten neu generiert beziehungsweise umgestaltet werden können. Beispielsweise können so Formen, Proportionen, Farben und/oder einzelne Details in den jeweiligen Bilddaten gezielt verändert werden.

Liegt das Designauswahlkriterium vor, wird anschließend ein digitales 3D-Modell aus dem Bilddatensatz durch einen Rekonstruktionsalgorithmus erzeugt werden, wobei die Rechenvorrichtung mittels des Rekonstruktionsalgorithmus das digitale 3D-Modell aus den Bilddaten der mehreren unterschiedlichen Perspektiven berechnet. Vorzugsweise können die mehreren unterschiedlichen Perspektiven derart vorgegeben sein, dass diese für den Rekonstruktionsalgorithmus die Berechnung des 3D-Modells ermöglichen. Die Anzahl der benötigten Perspektiven kann dabei Objektabhängig sein, wobei zumindest zwei Perspektiven, vorzugsweise 5 bis 10 Perspektiven, aus unterschiedlichen Winkeln auf das Objekt verwendet werden. Für die Rekonstruktion des digitalen 3D-Modells aus dem Bilddatensatz, der 2D-Ansichten des Objekts umfasst, können bekannte Rekonstruktionstechniken angewendet werden, die insbesondere auf neuronalen Netzwerken und/oder Photogrammetrie und/oder differenzierbaren Rendering beruhen können.

Schließlich wird das erzeugte digitale 3D-Modell als Designentwicklung für das Objekt bereitgestellt, wobei das Objekt und/oder ein reales 3D-Modell aus dem bereitgestellten digitalen 3D-Modell mittels einer Herstellungsanlage erzeugt wird. Das digitale 3D-Modell kann dabei beispielsweise einem CAD-Programm für eine weitere Entwicklung des Objekts, beispielsweise des Fahrzeugs, zur Verfügung gestellt werden. Das digitale 3D-Modell wird einer Herstellungsanlage bereitgestellt, die aus dem digitalen 3D-Modell ein reales 3D-Modell erzeugt, wobei die Herstellungsanlage in diesem Fall ein 3D-Drucker sein kann, und/oder das digitale 3D-Modell wird einer Herstellungsanlage, beispielsweise einer Produktionsstraße für Fahrzeugkarosserien, bereitgestellt, um das Objekt gemäß der Vorlage des digitalen 3D-Modells zu erzeugen.

Das Verfahren sieht vor, dass das Objekt und/oder ein reales 3D-Modell aus dem bereitgestellten digitalen 3D-Modell mittels einer Herstellungsanlage erzeugt wird. Das bedeutet, dass durch die Daten des digitalen 3D-Modells eine Herstellungsanlage gesteuert werden kann, die ein reales Objekt erzeugt. Vorzugsweise kann die Herstellungsanlage das Objekt mittels der Daten beziehungsweise Informationen des digitalen 3D-Modells automatisch produzieren, also ohne zusätzliche manuelle Werkschritte. Die Herstellungsanlage kann dabei beispielsweise auf einem additiven Fertigungsverfahren basieren, insbesondere umfassend einen 3D-Drucker oder eine Fotolithographieanlage. Alternativ oder zusätzlich kann die Herstellungsanlage eine Spritzgussmaschine aufweisen beziehungsweise die Spritzgussmaschine sein. Somit kann beispielsweise ein Prototyp hergestellt werden, der auf dem durch das Verfahren bereitgestellten digitalen 3D-Modell basiert. Es können letztendlich verschiedenartig ausgestaltete Objekte, wie beispielsweise eine Fahrzeugkarosserie oder eine Felge für ein Kraftfahrzeug einfach und kostengünstig hergestellt werden. Somit unterstützt das erfindungsgemäße Verfahren einen gesamten Herstellungsprozess des Objekts von einer Designentwicklung bis zur Herstellung des neu designten Objekts.

Durch die Erfindung ergibt sich der Vorteil, dass die Designentwicklung beschleunigt und gezielt ausführbar ist. Es können neue Design schnell abgeleitet werden, wodurch sich ein zeitlicher Aufwand für die Designentwicklung verkürzen lässt. Außerdem werden schnelle Iterationen und Weiterentwicklungen von bestehenden Designs und ein gezieltes Anpassen an ein bestehendes Branding oder verschiedene Designsprachen einer Marke möglich. Hierbei sind zudem keine Medienbrüche, das heißt kein Wechsel von beispielsweise Papierzeichnungen zu digitalen Objektrepräsentationen, erforderlich. Letztendlich wird eine abstrakte, aber dennoch gezielte und zum Beispiel vom Designer vorgegebene Interpolation und/oder Rekombination von künstlichen Basisbilddaten ermöglicht, um einfach und schnell eine Kontrolle von Designs und 3D-Geometrien und Stilrichtungen zu erhalten, die mit etablierten CAD/CAS-Ansätzen oft sehr aufwendig oder nicht möglich sind.

Die Erfindung umfasst auch Ausführungsformen, durch die sich zusätzliche Vorteile ergeben.

Eine Ausführungsform sieht vor, dass mehrere künstliche neuronale Netzwerke bereitgestellt werden, wobei ein jeweiliges künstliches neuronales Netzwerk für eine vorgegebene Perspektive auf das Objekt mittels Basisbilddaten von Objekten dieser Objektart aus dieser Perspektive angelernt wird. In entsprechender Weise kann dann das jeweilige künstliche neuronale Netzwerk zum Erzeugen des Bilddatensatzes nur die Bilddaten der jeweils angelernten Perspektive erzeugen. Mit anderen Worten können mehrere trainierte neuronale Netzwerke für eine jeweilige 2D-Ansicht angelernt werden, wobei die Basisbilddaten, die zum Anlernen verwendet werden, für das jeweilige neuronale Netzwerk aus der gleichen Perspektive bereitgestellt sind. So wird durch jedes dieser angelernten neuronalen Netzwerke auch nur eine 2D-Ansicht aus dieser Perspektive erzeugt, wobei durch alle angelernten neuronalen Netzwerke die mehreren Perspektiven bereitgestellt werden, die anschließend zur Rekonstruktion des 3D-Modells verwendet werden können. Beispielsweise können die künstlichen neuronalen Netzwerke generative Modelle sein, insbesondere StyleGAN 2 oder SWAGAN. Hierdurch ergibt sich der Vorteil, dass eine bevorzugte Ausführungsform zur Erzeugung der Bilddaten aus mehreren Perspektiven bereitgestellt werden kann.

Eine weitere Ausführungsform sieht vor, dass das zumindest eine künstliche neuronale Netzwerk mittels jeweiliger 2D-Ansichten von 3D-Objekten der Objektart angelernt wird, wobei die 2D-Ansichten aus mehreren vorgegebenen Perspektiven auf das jeweilige 3D-Objekt bereitgestellt werden. Mit anderen Worten wird das künstliche neuronale Netzwerk mit 3D-Objekten angelernt, wobei das jeweilige 3D-Objekt in mehrere vorgegebene Perspektiven gedreht werden kann und dann die daraus resultierende 2D-Ansicht zum Anlernen verwendet wird. Dabei können zum Beispiel reale oder digitale 3D-Objekte oder Modelle verwendet werden, die insbesondere digital in die unterschiedlichen Perspektiven gedreht werden. Zum Beispiel kann das 3D-Objekt zum Anlernen des künstlichen neuronalen Netzwerks in einem CAD-Tool vorliegen, durch das das 3D-Objekt dann in vorgegebene Perspektiven gedreht wird, um 2D-Ansichten zum Anlernen bereitzustellen. Somit kann das künstliche neuronale Netzwerk die 2D-Repräsentationen von 3D-Objekten erlernen und anschließend beim Erzeugen des Bilddatensatzes aus diesen angelernten 2D-Ansichten neue Bilddaten erzeugen. Alternativ kann ein in Hinsicht auf die Perspektiven heterogener Datensatz von Basisbilddaten des 3D-Objekts verwendet werden, um das zumindest eine künstliche neuronale Netzwerk anzulernen. Als künstliches neuronales Netzwerk kann hierbei beispielsweise Style-NERF verwendet werden. Durch diese Ausführungsform ergibt sich der Vorteil, dass das neuronale Netzwerk bereits mit konsistenten Basisbilddaten eines 3D-Objekts angelernt werden kann und somit Inkonsistenzen beim Erzeugen neuer Bilddaten reduziert werden können.

Vorzugsweise ist vorgesehen, dass das Designauswahlkriterium zumindest dann vorliegt, falls eine Bildeigenschaft in den mehreren Perspektiven der Bilddaten konsistent ist. Insbesondere kann geprüft werden, ob die Bildeigenschaft der Bilddaten in den mehreren unterschiedlichen Perspektiven gleich ist oder ob beispielsweise ein Stilbruch, insbesondere nichtzusammenhängende Formen zwischen den unterschiedlichen Perspektiven, vorhanden sind. Zum Beispiel kann im Falle einer Fahrzeugkarosserie überprüft werden, ob in einer Perspektive ein Kombi dargestellt ist und in einer anderen Perspektive eine Limousine, wobei in diesem Fall das Designauswahlkriterium nicht vorliegen würde. Das Designauswahlkriterium kann vorzugsweise automatisch überprüft werden, insbesondere durch ein weiteres neuronales Netzwerk, das die erzeugten Bilddaten dahingehend untersucht. Alternativ oder zusätzlich kann das Designauswahlkriterium von einem Designer überprüft werden, der den Bilddatensatz freigeben kann. Hierdurch ergibt sich der Vorteil, dass die Designentwicklung eines Objekts weiter vereinfacht werden kann.

Eine weitere Ausführungsform sieht vor, dass als künstliches neuronales Netzwerk ein generatives gegnerisches Netzwerk, GAN (Generative Adversarial Network), verwendet wird. Das erzeugende generische Netzwerk kann alternativ als eine Art generatives tiefes neuronales Netzwerk beschrieben werden. Das GAN ist eine algorithmische Architektur, die zwei künstliche neuronale Netzwerke verwendet. Die beiden künstlichen neuronalen Netzwerke dienen letztendlich dazu, synthetische, das heißt künstliche, neue Datensätze, insbesondere Bilddatensätze, zu generieren.

Das eine künstliche neuronale Netzwerk des GAN wird als Generator bezeichnet und erstellt den Bilddatensatz. Das andere künstliche neuronale Netzwerk des GAN wird als Diskriminator bezeichnet und bewertet die erstellten Bilddaten des Bilddatensatzes. Typischerweise bildet der Generator, mathematisch betrachtet, einen Vektor aus latenten Variablen auf einen gewünschten Ergebnisraum ab. Der Generator erlernt während des Trainierens, die Bilddaten des Bilddatensatzes nach einer ihm vorgegebenen Verteilung zu erzeugen. Der Diskriminator wird darauf trainiert, diese Ergebnisse des Generators von Daten aus der vorgegebenen Verteilung zu unterscheiden. Die vorgegebene Verteilung sind hier die Basisbilddaten. Am Ende des Trainierens ist der Generator derart ausgestaltet, Bilddaten zu erzeugen, die der Diskriminator nicht von den Bilddaten der Basisbilddaten unterscheiden kann. Dadurch soll sich die erzeugte Verteilung, das heißt der erzeugte Bilddatensatz, nach und nach einer echten Verteilung angleichen, das heißt zum Beispiel realistische Bilder von Objekten, wie beispielsweise eine Fahrzeugkarosserie, aufweisen.

Bevorzugt wird eine besondere Ausgestaltung des GAN verwendet, und zwar ein stylebasiertes GAN, wie zum Beispiel ein StyleGAN 1, StyleGAN 2 und/oder ein SWAGAN (Style and Wavelet Based GAN). Das erste künstliche neuronale Netzwerk des beispielsweise als StyleGAN 1 ausgebildeten stylebasierten GAN dient mathematisch betrachtet einer Abbildung von Zufallsvektoren in einem intermediären latenten Raum. Eine Datenausgabe des ersten künstlichen neuronalen Netzwerks wird zum Beispiel dem zweiten künstlichen neuronalen Netzwerk an unterschiedlichen adaptiven Instanznormalisierungsschichten (AdaIN für Adaptive Instance Normalisation) zugeführt und kontrolliert, dass die vom zweiten neuronalen Netzwerk erzeugten Bilddaten als realitätsnahe Bilddaten des Objekts ausgestaltet sind. Alternativ oder zusätzlich dazu kann die Datenausgabe des ersten künstlichen neuronalen Netzwerks dem zweiten künstlichen neuronalen Netzwerk an ähnlich funktionierenden Schichten zugeführt werden. Die ähnlich funktionierenden Schichten sind zum Beispiel im Falle des StyleGAN 2 sogenannte Demodulationen und/oder Modulationen. Das zweite neuronale Netzwerk kann als Synthetisierungsnetzwerk bezeichnet werden. Die Erzeugung und somit eine Generierung von Bilddaten durch das Synthetisierungsnetzwerk erfolgt stufenweise, wobei eine Bildauflösung bei 4x4 Pixeln anfängt und nach und nach mittels des künstlichen neuronalen Netzwerks verfeinert wird. Die latenten Vektoren werden auf unterschiedlichen Ebenen als Stylevektoren verwendet. Die Anzahl der Ebenen beträgt abhängig von der gewünschten Größe der generierten Bilddaten bis zu 18 Ebenen. Ausgegeben wird am Ende beispielsweise eine portable Netzwerkgrafik (Png Bilddatei). Welchen Einfluss ein bestimmter Stylevektor beziehungsweise latenter Vektor auf die generierten Bilddaten hat, hängt unter anderem von der gewählten Tiefe der jeweiligen AdaIN-Schicht ab.

Die vom Generator erzeugten Bilddaten weisen die Bildeigenschaften auf, wobei die Bildeigenschaften bei der Verwendung der stylebasierten GAN als Styles bezeichnet werden können. Die den ersten Ebenen zugeordneten Bildeigenschaften sind bevorzugt für globale Eigenschaften des abgebildeten Objekts verantwortlich. Die den unteren Ebenen zugeordneten Bildeigenschaften bestimmten bevorzugt lokale Eigenschaften des Objekts, wie zum Beispiel eine Farbgestaltung. Das Synthetisierungsnetzwerk kann je nach der gewählten Auflösung Bilddaten mit bis zu 18 Stylevektoren, das heißt 18 Bildeigenschaften, kontrollieren. Die aneinandergereihten Stylevektoren können auch als DNA-Vektoren bezeichnet werden.

Voraussetzung für ein erfolgreiches Trainieren des stylebasierten GAN sind die Basisbilddaten, die für das Trainieren verwendet werden. Hier verfügen die Basisbilddaten bevorzugt über eine große Vielfalt an Ausgestaltungen des Objekts. Bevorzugt können die Basisbilddaten zusätzlich über eine Hauptkomponentenanalyse PCA (Principal Component Analysis) im Fourierraum evaluiert werden. Die Ergebnisse dieser Evaluation werden mittels T-verteilter stochastischer Nachbarschaftseinbettung T-SNE (T distributed stochastic neighbor embeddinng) in einen zweidimensionalen Bildraum überführt. Dadurch können schon frühzeitig sich besonders ähnliche Bilddaten identifiziert und zum Beispiel aussortiert werden.

Basierend auf Methoden der künstlichen Intelligenz wird also durch das Trainieren des GAN, insbesondere des stylebasierten GAN, mit einem für das gewünschte Objekt geeigneten Basisbilddatensatz erreicht, dass zuverlässige realitätsnahe neue Bilddaten des Objekts erzeugt und somit ein geeigneter Bilddatensatz für das Verfahren bereitgestellt wird.

Eine weitere Ausführungsform sieht vor, dass die Bilddaten einer oder mehrerer Perspektiven mittels einer Veränderung des Bildeigenschaftskriteriums neu erzeugt werden, indem die Bilddaten interpoliert und/oder rekombiniert werden. Mit anderen Worten können jeweils zumindest zwei verschiedene Bilddaten zum Erzeugen des neuen und veränderten Bilddatensatzes verwendet werden, um eine Variation der jeweiligen einzelnen bereitgestellten Bilddaten durchzuführen. Vorzugsweise können durch das angelernte künstliche neuronale Netzwerk zunächst mehrere Bilddaten für jede Perspektive erzeugt werden, wobei durch Veränderung des Bildeigenschaftskriterium Bildeigenschaften von zwei oder mehreren der jeweiligen Bilddaten einer jeweiligen Perspektive durch Interpolation und/oder Rekombination neu erstellt werden können, wodurch gänzlich neue Bilddaten erzeugt werden können. Die Funktionsweise des GAN zur Interpolation und Rekombination ist dabei bereits weiter oben beschrieben. Es können somit ausgehend von dem mithilfe des zumindest einen künstlichen neuronalen Netzwerks erzeugten Bilddatensatz durch Auswahl der zumindest zwei Bilddaten und deren Interpolation und/oder Rekombination als neue Bilddaten Kombinationsbilddaten erzeugt werden. Die Kombinationsbilddaten beschreiben bevorzugt ein Bild eines vom künstlichen neuronalen Netzwerk neu designten Objekts, das heißt eines bisher zumindest dem künstlichen neuronalen Netzwerk nicht bekannten Objekts. Alternativ können die latenten Vektoren zufällig im latenten Raum verändert werden, um neue Bilddaten zu erzeugen. Durch diese Ausführungsform ergibt sich der Vorteil, dass gezielt eine Variation der Bildeigenschaften durchgeführt werden kann und somit eine Feineinstellung der Designentwicklung ermöglicht wird.

Vorzugsweise ist vorgesehen, dass das Bildeigenschaftskriterium mittels einer Anpassung latenter Vektoren verändert wird. Mit anderen Worten ist das Bildeigenschaftskriterium durch die latenten Vektoren definiert. Dabei können die latenten Vektoren auf unterschiedliche Ebenen der angelernten Basisbilddaten zugreifen und somit auf Bildeigenschaften, die die erzeugten Bilddaten für den Bilddatensatz aufweisen sollen. Insbesondere kann somit, beispielsweise durch einen Designer, gezielt eine Bildeigenschaft in einen oder mehreren Bilddaten verschiedener Perspektiven verändert werden, ohne dafür in aufwändiger Weise komplett neue 2D-Skizzen anfertigen zu müssen. Vorzugsweise kann die Veränderung der latenten Vektoren mittels einer grafischen Benutzeroberfläche durchgeführt werden, in der die Abhängigkeiten der latenten Vektoren bereitgestellt sind. Das bedeutet, dass durch die graphische Benutzeroberfläche bekannt sein kann, welche Bildeigenschaft durch die Veränderung des jeweiligen latenten Vektors angepasst wird. Insbesondere kann der Designer einen von den latenten Vektoren beschriebenen Punkt im latenten Raum entlang einer Hauptkomponente verschieben und somit die Ausprägung spezifischer Eigenschaften des Objekts verändern. Hierdurch ergibt sich der Vorteil, dass auf einfache Art und Weise Bilddaten angepasst werden können. Vorzugsweise ist vorgesehen, dass Bildeigenschaften, die durch Veränderung des Bildeigenschaftskriteriums angepasst werden, folgende umfassen: eine Dimension des Objekts, also beispielsweise Abmessungen beziehungsweise eine Größe des Objekts; Proportionen des Objekts, eine stilistische Richtung des Objekts; eine Farbe des Objekts und/oder Formen einzelner Details des Objekts. Diese können beispielsweise mittels der zuvor beschriebenen latenten Vektoren angepasst werden, indem unterschiedliche Ebenen der Basisbilder angesteuert werden.

Ein weiterer Aspekt der Erfindung betrifft eine Designvorrichtung zum Bereitstellen eines 3D-Modells für eine Designentwicklung eines Objekts, wobei die Designvorrichtung eine Rechenvorrichtung und eine Herstellungsanlage umfasst, wobei die Rechenvorrichtung dazu ausgebildet ist, ein Verfahren nach einem der vorhergehenden Ausführungsformen durchzuführen. Beispielsweise kann die Designvorrichtung eine Rechenvorrichtung, insbesondere einen Computer, umfassen, auf dem das zumindest eine angelernte künstliche neuronale Netzwerk betrieben werden kann. Vorzugsweise kann dieses über eine grafische Benutzeroberfläche gesteuert werden und zumindest einen Bildschirm aufweisen, in dem einzelne Schritte des Verfahrens überwacht werden können und/oder das bereitgestellte digitale 3D-Modell angezeigt werden kann. Auch kann die Designvorrichtung eine Herstellungsanlage umfassen, zu der das digitale 3D-Modell übermittelt wird und die anschließend ein reales 3D-Modell erzeugen kann. Hierbei ergeben sich gleiche Vorteile und Variationsmöglichkeiten wie bei dem Verfahren.

Für Anwendungsfälle oder Anwendungssituationen, die sich bei dem Verfahren ergeben können und die hier nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Zu der Erfindung gehört auch eine Steuervorrichtung für die Designvorrichtung. Die Steuervorrichtung kann eine Datenverarbeitungsvorrichtung oder eine Prozessoreinrichtung aufweisen, die dazu eingerichtet ist, eine Ausführungsform des erfindungsgemäßen Verfahrens durchzuführen. Die Prozessoreinrichtung kann hierzu zumindest einen Mikroprozessor und/oder zumindest einen Mikrocontroller und/oder zumindest einen FPGA (Field Programmable Gate Array) und/oder zumindest einen DSP (Digital Signal Processor) aufweisen. Des Weiteren kann die Prozessoreinrichtung Programmcode aufweisen, der dazu eingerichtet ist, bei Ausführen durch die Prozessoreinrichtung die Ausführungsform des erfindungsgemäßen Verfahrens durchzuführen. Der Programmcode kann in einem Datenspeicher der Prozessoreinrichtung gespeichert sein. Alternativ oder zusätzlich kann das Verfahren, das als Programmcode vorliegen kann, durch eine Rechnerwolke (Cloud computing) bereitgestellt werden.

Zu der Erfindung gehören auch Weiterbildungen der erfindungsgemäßen Designvorrichtung, die Merkmale aufweisen, wie sie bereits im Zusammenhang mit den Weiterbildungen des erfindungsgemäßen Verfahrens beschrieben worden sind. Aus diesem Grund sind die entsprechenden Weiterbildungen der erfindungsgemäßen Designvorrichtung hier nicht noch einmal beschrieben.

Bevorzugt kann mit dem Verfahren ein Modell einer Kraftfahrzeugkomponente hergestellt werden, insbesondere für einen Personenkraftwagen, Lastkraftwagen, Personenbus und/oder ein Motorrad.

Als eine weitere Lösung umfasst die Erfindung auch ein computerlesbares Speichermedium, umfassend Befehle, die bei der Ausführung durch einen Computer oder einen Computerverbund diesen veranlassen, eine Ausführungsform des erfindungsgemäßen Verfahrens auszuführen. Das Speichermedium kann z.B. zumindest teilweise als ein nicht-flüchtiger Datenspeicher (z.B. als eine Flash-Speicher und/oder als SSD - solid state drive) und/oder zumindest teilweise als ein flüchtiger Datenspeicher (z.B. als ein RAM - random access memory) ausgestaltet sein. Durch den Computer oder Computerverbund kann eine Prozessorschaltung mit zumindest einem Mikroprozessor bereitgestellt sein. Die Befehle können als Binärcode oder Assembler und/oder als Quellcode einer Programmiersprache (z.B. C) bereitgestellt sein.

Die Erfindung umfasst auch die Kombinationen der Merkmale der beschriebenen Ausführungsformen. Die Erfindung umfasst also auch Realisierungen, die jeweils eine Kombination der Merkmale mehrerer der beschriebenen Ausführungsformen aufweisen, sofern die Ausführungsformen nicht als sich gegenseitig ausschließend beschrieben wurden. Der Schutzumfang der Erfindung wird durch die anhängenden Ansprüche festgelegt.

Im Folgenden sind Ausführungsbeispiele der Erfindung beschrieben. Hierzu zeigt:
- Fig. 1: eine schematisch dargestellte Designvorrichtung gemäß einer beispielhaften Ausführungsform;
- Fig. 2: ein schematisches Verfahrensdiagramm gemäß einer beispielhaften Ausführungsform.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden. Daher soll die Offenbarung auch andere als die dargestellten Kombinationen der Merkmale der Ausführungsformen umfassen. Des Weiteren sind die beschriebenen Ausführungsformen auch durch weitere der bereits beschriebenen Merkmale der Erfindung ergänzbar.

In den Figuren bezeichnen gleiche Bezugszeichen jeweils funktionsgleiche Elemente.

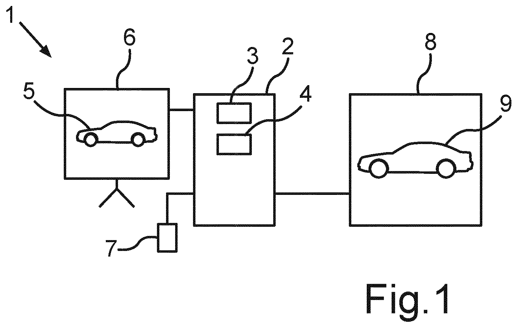

In Fig. 1 ist eine Designvorrichtung 1 skizziert, die zum Durchführen eines Verfahrens zum Bereitstellen eines 3D-Modells für eine Designentwicklung eines Objekts ausgebildet sein kann. Die Designvorrichtung 1 kann eine Rechenvorrichtung 2, insbesondere einen Computer, umfassen, der eine Prozessoreinrichtung 3 und ein Speichermedium 4 aufweist. So kann auf dem Speichermedium 4, das beispielsweise eine Festplatte des Computers ist, Programmcode für zumindest ein künstliches neuronales Netzwerk und/oder Basisbilddaten von Objekten gespeichert sein, wobei die Prozessoreinrichtung 3 dazu ausgebildet sein kann, den Programmcode des künstlichen neuronalen Netzwerks auszuführen, um ein digitales 3D-Modell 5 eines Objekts zu generieren, wobei das Objekt in diesem Beispiel ein Kraftfahrzeug sein kann. Alternativ kann die Prozessoreinrichtung 3 beispielsweise in einer Cloud bereitgestellt sein.

Die Rechenvorrichtung 2 kann mit einer Anzeigeeinrichtung 6 zum Anzeigen des digitalen 3D-Modells 5 bereitgestellt sein, wobei über die Anzeigeeinrichtung 6 vorzugsweise über eine grafische Benutzeroberfläche ein Verfahren zum Bereitstellen des digitalen 3D-Modells 5 überwacht und/oder angepasst werden kann. Insbesondere kann die Designvorrichtung 1 Eingabeeinrichtungen 7 umfassen, mittels den Einstellungen, insbesondere auf der grafischen Benutzeroberfläche, geändert werden können. Die Eingabeeinrichtungen können beispielsweise eine Computertastatur, eine Computermaus und/oder berührungsempfindliche Eingabefelder umfassen.

Die Designvorrichtung 1 umfasst vorzugsweise zusätzlich eine Herstellungsanlage 8, die als additive Herstellungsanlage 8, zum Beispiel als 3D-Drucker oder als Fotolithografie-Anlage, ausgebildet sein kann. Insbesondere kann die Herstellungsanlage 8 dazu ausgebildet sein, das digitale 3D-Modell 5 zu einem realen 3D-Modell 9 umzusetzen, also in diesem Beispiel ein reales Modell des Kraftfahrzeugs.

Jeweilige Daten können zwischen den einzelnen Vorrichtungen der Designvorrichtung 1, insbesondere zwischen der Rechenvorrichtung 2, der Anzeigeeinrichtung 6 und/oder der Herstellungsanlage 8 drahtgebunden und/oder drahtlos übermittelt werden.

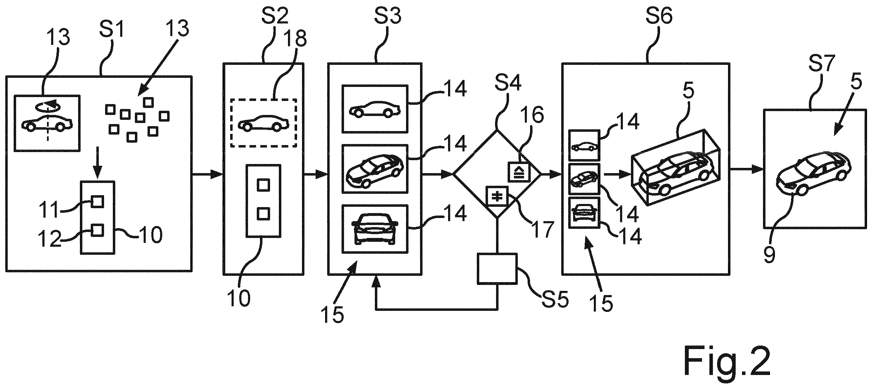

In Fig. 2 ist ein Verfahren zum Bereitstellen eines 3D-Modells 5 eines Objekts gemäß einer beispielhaften Ausführungsform dargestellt. Hierbei kann in einem ersten Verfahrensschritt S1 ein künstliches neuronales Netzwerk 10 angelernt werden, wobei das künstliche neuronale Netzwerk 10 vorzugsweise ein generatives gegnerisches Netzwerk, ein sogenanntes GAN (generative adversarial network) ist. Ein solches GAN 10 umfasst zwei künstliche neuronale Netzwerke 11, 12, von denen ein erstes Netzwerk als Generator 11 und ein zweites als Diskriminator 12 bezeichnet wird. Das GAN 10 kann entweder mit mehreren Basisbilddaten 13 eines Objekts angelernt werden, wobei die Basisbilddaten vorzugsweise aus unterschiedlichen Perspektiven auf das Objekt bereitgestellt werden und für jede dieser Perspektiven ein eigenes GAN 10 angelernt wird. Hierbei eignet sich beispielsweise ein sogenanntes StyleGAN 2, SWAGAN oder StyleNERF. Alternativ kann als Basisbilddaten 13 ein 3D-Objekt bereitgestellt werden, dass in mehrere unterschiedliche 2D-Ansichten gedreht werden kann und so vorgegebene Perspektiven auf das jeweilige 3D-Objekt bereitgestellt werden. In diesem Beispiel können die Basisbilddaten eine Fahrzeugkarosserie sein.

Jedoch können auch andere Objektarten mittels entsprechender Basisbilddaten angelernt werden.

In einem Verfahrensschritt S2 kann dem angelernten GAN 10 eine Objektart18 vorgegeben werden, für die das GAN 10 Bilder erzeugen soll, wobei das GAN 10 vorzugsweise zuvor für die vorgegebene Objektart 18 mittels der Basisbilddaten 13 der Objektart18 angelernt wurde. In diesem Beispiel kann also als Objektart18 vorgegeben werden, dass eine Fahrzeugkarosserie als Designentwicklung bereitgestellt werden soll.

In einem Schritt S3 kann das GAN 10 ein Bilddatensatz 15 der vorgegebenen Objektart18 erzeugen, wobei hierfür das angelernte GAN 10 Bildmerkmale, die aus den Basisbilddaten 13 beziehungsweise Trainingsdaten angelernt sind, interpoliert und/oder rekombiniert, um neue Bilddaten 14 der Objektart18 zu generieren, insbesondere Bilddaten 14 für mehrere unterschiedliche Perspektiven des Objekts.

In einem Schritt S4 kann der erzeugte Bilddatensatz 15 daraufhin geprüft werden, ob ein Designauswahlkriterium vorliegt 16 oder das Designauswahlkriterium nicht vorliegt 17, wobei das Designauswahlkriterium beispielsweise sein kann, ob eine Bildeigenschaft in den Bilddaten 14 konsistent ist oder nicht. So kann beispielsweise geprüft werden, ob in den jeweiligen Perspektiven eine Farbe der Karosserie konsistent ist und/oder Formen zusammenpassen. Auch kann beispielsweise durch einen Designer überprüft werden, ob ein Stil den Vorstellungen entspricht oder ob die Bilddaten 14 geändert werden sollen. Ist dies der Fall und das Designauswahlkriterium liegt nicht vor 17 kann in einem Schritt S5 eine oder mehrere Perspektiven durch das GAN 10 neu generiert werden, indem ein Bildeigenschaftskriterium verändert wird. Hierbei kann insbesondere ein oder mehrere latente Vektoren angepasst werden, die unterschiedliche Ebenen der Basisbilddaten ansteuern und somit insbesondere eine Dimension, Proportionen, eine stilistische Richtung, eine Farbe und/oder Formen einzelner Details verändern können. Vorzugsweise werden hierfür durch Veränderung des Bildeigenschaftskriteriums Bildeigenschaften der Bilddaten, die für jede Perspektive vorliegen können, interpoliert und/oder rekombiniert, um die Bildeigenschaften gezielt anzupassen. Folglich kann beispielsweise ein Designer komplett neue Bilddaten 14 erstellen oder nur einzelne Bildeigenschaften der Bilddaten 14 in einer oder mehreren Perspektiven abändern, um zu einem neuen Bilddatensatz 15 zu gelangen. Die Bilddaten 14 des Bilddatensatzes 15 stellen dabei 2D-Ansichten aus den unterschiedlichen Perspektiven bereit, die beispielsweise durch die Anzeigeeinrichtung 6 angezeigt und überprüft werden können.

Sind die Bilddaten konsistent und der Designer mit den Repräsentationen der Bilddaten 14 in den verschiedenen Perspektiven zufrieden, kann das Designauswahlkriterium vorliegen 16 und in einem Schritt S6 kann dann mittels eines Rekonstruktionsalgorithmus das digitale 3D-Modell 5 berechnet werden. Der Rekonstruktionsalgorithmus kann hierbei beispielsweise ein weiteres neuronales Netzwerk sein, das aus den Ansichten der Bilddaten 14 das 3D-Modell 5 erstellt und/oder mit Methoden der Photogrammmetrie und/oder des differenzierbaren Renderings kann auf das 3D-Modell 5 zurückgerechnet werden.

Schließlich kann in einem Schritt S7 das erzeugte digitale 3D-Modell 5 als Designentwicklung für das Objekt, in diesem Fall die Fahrzeugkarosserie, bereitgestellt werden, wobei vorzugsweise eine Herstellungsanlage 8 ein reales 3D-Modell 9 erzeugen kann, beispielsweise ein Modell aus Kunststoff, das durch einen 3D-Drucker erzeugt wird.

Insgesamt zeigen die Beispiele, wie durch die Erfindung eine GAN basierte Generation von 3D-Geometrien erreicht werden kann.

## Patentansprüche

1. Verfahren zum Bereitstellen eines 3D-Modells (5) für eine Designentwicklung eines Objekts durch Durchführung des Verfahrens auf einer Rechenvorrichtung (2), umfassend die Schritte:
- Vorgeben (S2) einer Objektart (18) für zumindest ein angelerntes künstliches neuronales Netzwerk (10), wobei das mindestens eine künstliche neuronale Netzwerk (10) mit einer Mehrzahl von Basisbilddaten (13) von Objekten dieser Objektart (18) angelernt wird;
- Erzeugen (S3) eines Bilddatensatzes (15) der vorgegebenen Objektart durch das angelernte künstliche neuronale Netzwerk (10), wobei das künstliche neuronale Netzwerk (10) als Bilddatensatz (15) Bilddaten (14) der Objektart (18) aus mehreren unterschiedlichen Perspektiven bereitstellt, die aus den Basisbilddaten (13) ermittelt werden, mit denen das künstliche neuronale Netzwerk (10) angelernt wurde;
- Automatisches Prüfen (S4) des erzeugten Bilddatensatzes (15) durch ein weiteres neuronales Netzwerk auf Vorliegen eines Designauswahlkriteriums, wobei falls das Designauswahlkriterium nicht vorliegt (17), Bilddaten (14) einer oder mehrerer Perspektiven mittels einer Veränderung eines Bildeigenschaftskriteriums (S5) neu erzeugt werden;
- Erzeugen (S6) eines digitalen 3D-Modells (5) aus dem Bilddatensatz (15), für den das Designauswahlkriterium vorliegt (16), durch einen Rekonstruktionsalgorithmus, wobei die Rechenvorrichtung (2) mittels des Rekonstruktionsalgorithmus das digitale 3D-Modell (5) aus den Bilddaten (14) der mehreren unterschiedlichen Perspektiven berechnet;
- Bereitstellen (S7) des erzeugten digitalen 3D-Modells (5) als Designentwicklung für das Objekt,
wobei das Objekt und/oder ein reales 3D-Modell (9) aus dem bereitgestellten digitalen 3D-Modell (5) mittels einer Herstellungsanlage (8) erzeugt wird.

2. Verfahren nach Anspruch 1, wobei mehrere künstliche neuronale Netzwerke (10) bereitgestellt werden, wobei ein jeweiliges künstliches neuronales Netzwerk (10) für eine vorgegebene Perspektive auf das Objekt mittels Basisbilddaten (13) von Objekten dieser Objektartaus dieser Perspektive angelernt wird.

3. Verfahren nach Anspruch 1, wobei das zumindest eine künstliche neuronale Netzwerk (10) mittels jeweiliger 2D-Ansichten von 3D-Objekten (13) der Objektartangelernt wird, wobei die 2D-Ansichen aus mehreren vorgegebenen Perspektiven auf das jeweilige 3D-Objekt bereitgestellt werden.

4. Verfahren nach einem der vorhergehenden Ansprüche, wobei das Designauswahlkriterium zumindest dann vorliegt (16), falls eine Bildeigenschaft in den mehreren Perspektiven der Bilddaten konsistent ist.

5. Verfahren nach einem der vorhergehenden Ansprüche, wobei als künstliches neuronales Netzwerk (10) ein generatives gegnerisches Netzwerk, GAN, verwendet wird.

6. Verfahren nach einem der vorhergehenden Ansprüche, wobei die Bilddaten (14) einer oder mehrerer Perspektiven mittels einer Veränderung des Bildeigenschaftskriteriums neu erzeugt werden, indem die Bilddaten (14) interpoliert und/oder rekombiniert werden.

7. Verfahren nach einem der vorhergehenden Ansprüche, wobei das Bildeigenschaftskriterium mittels einer Anpassung latenter Vektoren verändert wird.

8. Verfahren nach einem der vorhergehenden Ansprüche, wobei Bildeigenschaften, die durch Veränderung des Bildeigenschaftskriteriums angepasst werden, folgende umfassen:
- eine Dimension des Objekts;
- Proportionen des Objekts;
- eine stilistische Richtung des Objekts;
- eine Farbe des Objekts;
- Formen einzelner Details des Objekts.

9. Designvorrichtung (1) zum Bereitstellen eines 3D-Modells für eine Designentwicklung eines Objekts, wobei die Designvorrichtung eine Rechenvorrichtung (2) und eine Herstellungsanlage (8) umfasst, wobei die Rechenvorrichtung (2) dazu ausgebildet ist, ein Verfahren nach einem der vorhergehenden Ansprüche durchzuführen.

## Claims

1. A method of providing a 3D model (5) for design development of an object, by performing the method on a computing device (2), comprising the steps of:
- specifying (S2) an object type (18) for at least one trained artificial neural network (10), wherein the at least one artificial neural network (10) is trained with a plurality of basic image data (13) of objects of this object type (18);
- generating (S3) an image data set (15) of the predetermined object type by the trained artificial neural network (10), wherein the artificial neural network (10) provides an image data set (15) of image data (14) of the object type (18) from a plurality of different perspectives which are determined from the acquired basic image data (13), with which the artificial neural network (10) was trained;
- automatic checking (S4) the generated image data set (15) by a further neural network for the presence of a design selection criterion, wherein if the design selection criterion is not met (17), image data (14) of one or more perspectives are newly generated by means of a change of an image property criterion (S5);
- generating (S6) a digital 3D model (5) from the image data set (15) for which the design selection criterion is met (16) by a reconstruction algorithm, wherein the computing device (2) calculates, by means of the reconstruction algorithm, the digital 3D model (5) from the image data (14) of the plurality of different perspectives;
- providing (S7) the generated digital 3D model (5) as design development for the object,
wherein the object and/or a real 3D model (9) is generated from the provided digital 3D model (5) by means of a production system (8).

2. The method according to claim 1, wherein multiple artificial neural networks (10) are provided, wherein a respective artificial neural network (10) is trained for a predetermined perspective on said object for said perspective by means of basic image data (13) of objects of said object type.

3. The method of claim 1, wherein the at least one artificial neural network (10) is trained by means of respective 2D views of 3D objects (13) of the object type, wherein the 2D views are provided from a plurality of predetermined perspectives on the respective 3D object.

4. The method according to any one of the preceding claims, wherein the design selection criterion is met (16) at least if an image property is consistent in the plurality of perspectives of the image data.

5. The method according to any one of the preceding claims, wherein a generative adversarial network, GAN, is used as the artificial neural network (10).

6. The method according to any one of the preceding claims, wherein the image data (14) of one or more perspectives is regenerated by changing the image property criterion by interpolating and/or recombining the image data (14).

7. The method according to any one of the preceding claims, wherein the image property criterion is varied by means of latent vector matching.

8. The method according to any one of the preceding claims, wherein image properties adapted by changing the image property criterion comprise:
- a dimension of the object;
- proportions of the object;
- a stylistic direction of the object;
- a color of the object;
- shapes of individual details of the object.

9. A design device (1) for providing a 3D model for a design development of an object, wherein the design device comprises a computing device (2) and a production system (8), wherein the computing device (2) is configured to carry out a method according to any one of the preceding claims.

## Revendications

1. Procédé destiné à fournir un modèle 3D (5) pour un développement de design d'un objet en mettant en œuvre ledit procédé sur un dispositif de calcul (2), comprenant les étapes consistant à :
- spécifier (S2) un type d'objet (18) pour au moins un réseau neuronal artificiel (10) entraîné, le au moins un réseau neuronal artificiel (10) étant entraîné avec une pluralité de données d'image de base (13) provenant d'objets de ce type d'objet (18) ;
- générer (S3) un ensemble de données d'image (15) du type d'objet spécifié via le réseau neuronal artificiel (10), le réseau neuronal artificiel (10) fournissant, sous forme d'ensemble de données d'image (15), des données d'image (14) du type d'objet (18) à partir de plusieurs perspectives différentes qui ont été déterminées à partir des données d'image de base (13) avec lesquelles le réseau neuronal artificiel (10) a été entraîné ;
- vérifier automatiquement (S4), par un réseau neuronal supplémentaire, l'ensemble de données d'image (15) généré afin de déterminer la présence d'un critère de sélection de design, dans lequel, lorsque le critère de sélection de design n'est pas présent (17), des données d'image (14) d'une ou plusieurs perspectives sont de nouveau générées au moyen d'un changement d'un critère de propriété d'image (S5) ;
- générer (S6), par un algorithme de reconstruction, un modèle 3D numérique (5) à partir de l'ensemble de données d'image (15) pour lequel le critère de sélection de design est présent (16), le dispositif de calcul (2) calculant, au moyen de l'algorithme de reconstruction, le modèle 3D numérique (5) à partir des données d'image (14) des différentes perspectives ;
- fournir (S7) le modèle 3D numérique (5) généré en tant que développement de design pour l'objet,
l'objet et/ou un modèle 3D réel (9) étant généré au moyen d'une installation de production (8), à partir du modèle 3D numérique (5) fourni.

2. Procédé selon la revendication 1, dans lequel plusieurs réseaux neuronaux artificiels (10) sont fournis, un réseau neuronal artificiel (10) respectif étant entraîné pour une perspective spécifiée sur l'objet, au moyen de données d'image de base (13) provenant d'objets de ce type d'objet pour cette perspective.

3. Procédé selon la revendication 1, dans lequel le au moins un réseau neuronal artificiel (10) est entraîné au moyen de vues 2D respectives d'objets 3D (13) du type d'objet, les vues 2D étant fournies à partir de plusieurs perspectives spécifiées de l'objet 3D respectif.

4. Procédé selon l'une des revendications précédentes, dans lequel le critère de sélection de design est au moins présent (16) si une propriété d'image est cohérente dans les différentes perspectives des données d'image.

5. Procédé selon l'une des revendications précédentes, dans lequel un réseau antagoniste génératif, GAN, est utilisé comme réseau neuronal artificiel (10).

6. Procédé selon l'une des revendications précédentes, dans lequel les données d'image (14) d'une ou plusieurs perspectives sont de nouveau générées au moyen d'un changement du critère de propriété d'image en interpolant et/ou en recombinant les données d'image (14).

7. Procédé selon l'une des revendications précédentes, dans lequel le critère de propriété d'image est changé au moyen d'une adaptation de vecteurs propres.

8. Procédé selon l'une des revendications précédentes, dans lequel des propriétés d'image adaptées en changeant le critère de propriété d'image, comprennent les éléments suivants :
- une dimension de l'objet ;
- des proportions de l'objet ;
- une tendance stylistique de l'objet ;
- une couleur de l'objet ;
- des formes de détails individuels de l'objet.

9. Dispositif de design (1) pour fournir un modèle 3D pour un développement de design d'un objet, le dispositif de design comprenant un dispositif de calcul (2) et une installation de production (8), le dispositif de calcul (2) étant configuré pour mettre en œuvre un procédé selon l'une des revendications précédentes.
